**Europäisches Patentamt**

**European Patent Office**

**Office européen des brevets**

(19)

(11) Veröffentlichungsnummer : **0 319 470 B1**

(12) ## EUROPÄISCHE PATENTSCHRIFT

(45) Veröffentlichungstag der Patentschrift :
**21.08.91 Patentblatt 91/34**

(51) Int. Cl.$^5$ : **H03L 1/02, H03K 17/95**

(21) Anmeldenummer : **88810790.1**

(22) Anmeldetag : **16.11.88**

(54) Verfahren und Schaltung zur Reduktion der Temperaturabhängigkeit der Schwingparameter eines Oszillators.

(30) Priorität : **01.12.87 CH 4679/87**

(43) Veröffentlichungstag der Anmeldung :
**07.06.89 Patentblatt 89/23**

(45) Bekanntmachung des Hinweises auf die Patenterteilung :
**21.08.91 Patentblatt 91/34**

(84) Benannte Vertragsstaaten :
**AT BE DE FR GB IT NL SE**

(56) Entgegenhaltungen :
**EP-A- 0 070 796
DE-A- 2 604 485
DE-A- 3 513 403**

(73) Patentinhaber : **Heimlicher, Peter
Klein-Schoenberg 112
CH-1700 Fribourg (CH)**

(72) Erfinder : **Heimlicher, Peter
Klein-Schoenberg 112
CH-1700 Fribourg (CH)**

(74) Vertreter : **Steiner, Martin et al
c/o AMMANN PATENTANWÄLTE AG BERN
Schwarztorstrasse 31
CH-3001 Bern (CH)**

## Beschreibung

Die vorliegende Erfindung betrifft ein Verfahren zur Reduktion der Temperaturabhänigkeit der Schwingparameter eines LC-Oszillators.

Oszillatoren, welche einen LC-Schwingkreis als frequenzbestimmmendes Element verwenden, werden z.B. in induktiven Näherungsschaltern verwendet. Dabei dämpft ein Messplättchen bei Annäherung an die Spule des Kreises dessen Güte, was durch eine Auswerteschaltung zur Erzeugung eines Ausgangssignales benutzt wird.

Es ist bekannt, die Temperaturabhängigkeit der Schwingparameter des Schwingkreises zu eliminieren, und zwar entweder nur die Hauptkomponente, die sich aus dem temperaturabhängigen Widerstand der Schwingkreisspule ergibt (EP-A-0070796), oder aber zusätzlich auch die temperaturunabhängigen Verluste (DE-A-3513403). Während im ersten Falle ein temperaturabhängiger Rückkoppelungspfad unter Nutzung des temperaturabhängigen Spulenwiderstandes vorgesehen ist, sind im zweiten Falle getrennte Rückkoppelungspfade vorgesehen, von welchen der eine temperaturabhängig ist, um den Einfluss der temperaturabhängigen Verluste zu eliminieren während der andere temperaturunabhängig ist, um die temperaturunabhängigen Verluste zu eliminieren.

Eine Berücksichtigung aller Einflüsse ist damit jedoch nicht erzielt. Die Schwingkreisparameter werden durch die variable Rückwirkung bzw. Bedämpfung des Schwingkreises durch das erwähnte Messplättchen oder einen entsprechenden leitenden Teil ebenfalls beeinflusst. Ziel vorliegender Erfindung ist es nun, auch diese variablen Einflüsse zu berücksichtigen und dadurch eine weitere Verbesserung der Temperaturunabhängigkeit zu erzielen. Die erfindungsgemässe Lösung dieser Aufgabe ist in den Ansprüchen 1 bzw. 6 angegeben. Es zeigt sich, dass eine Veränderung im temperaturunabhängigen Rückkoppelungspfad ausreicht, um eine praktisch vollkommene Kompensation zu erzielen, obwohl die äussere Bedämpfung des Schwingkreises an sich auch nicht temperaturunabhängig ist.

Die Erfindung wird nun anhand der Zeichnung näher erläutert, in welcher

Fig. 1        ein Ersatzschaltbild zur Darstelung der Verluste im Schwingkreis zeigt,
Fig. 2        zeigt den grundlegenden Aufbau einer Schaltung gemäss der Erfindung, und die
Fig. 3 bis 5   zeigen Ausführungsbeispiele.

Der wirkliche Verlauf der Gesamtverluste wird durch Ueberlagerung nachgebildet.

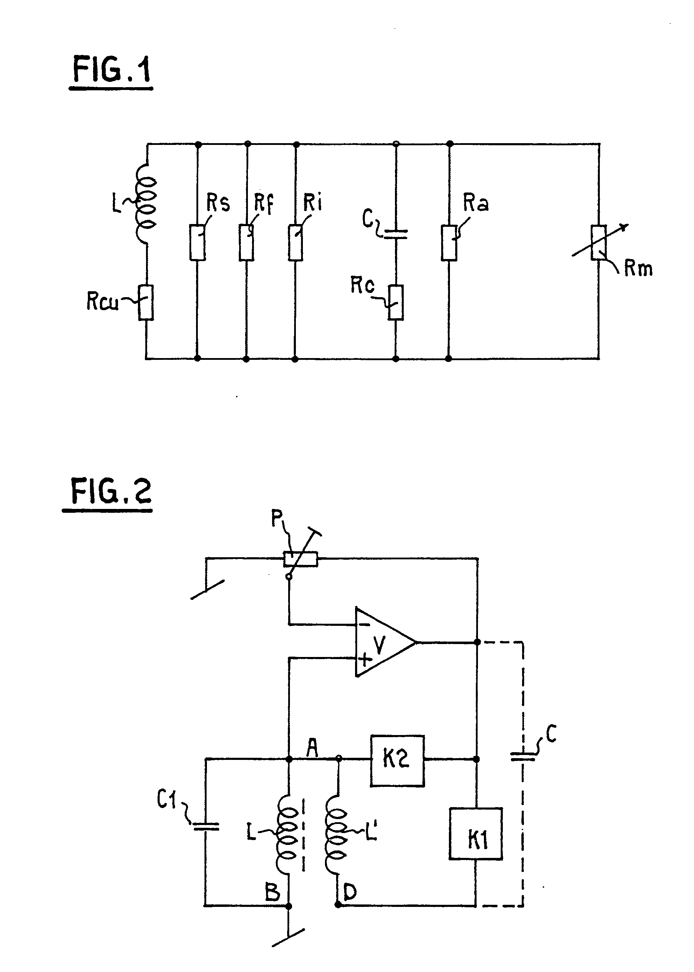

Im Ersatzschema des LC-Schwingkreises gemäss Fig. 1 entsprechen die eingezeichneten Widerstände folgenden Verlusten :

Rcu   Kupferwiderstand der Schwingkreisspule
Rs    Skineffekt — Verluste
Rf    Kernverluste
Ri    Dielektrische Verluste in den Isolationen (ausgenommen in C), vor allem in der Wicklungsisolation
Rc    Kondensatorverluste
Ra    Verluste in den internen Abschirmungen und im Gehäuse
Rm    Aeussere Verluste, vor allem im Messplättchen eines Näherungsschalters

Ein typischer Vertreter der ersten Gruppe ist selbstverständlich Rcu. Zur zweiten Gruppe gehören weitgehend Rm und Rc (sofern C ein Keramikkondensator ist). Die anderen Verluste können durch Ueberlagerung nachgebildet werden.

Von besonderem Interesse ist die Verlustquelle Rm, d.h. die vom Messplättchen verursachten Verluste. Diese Verluste ändern mit der Stärke der Bedämpfung, im Falle eines induktiven Näherungsschalters mit dem Abstand des Messplättchens von der Spule L, während alle anderen Verluste in diesem Fall konstant bleiben.

Fig 2 zeigt die prinzipielle Anwendung des Verfahrens auf einen LC-Oszillator gemäss EP-A-0070796. Diese bekannte Schaltung weist einen Schwingkreis LC1 mit bifilar gewickelter Spule L, L' auf. Ein Verstärker V mit einem Potentiometer P im Gegenkoppelungskreis unterhält bei der bekannten Schaltung die Schwingung durch Rückkoppelung über einen Kondensator C an die Klemme D der Spule L' der bifilaren Schwingkreisspule. Es erfolgt damit eine von Rcu abhängige Rückkoppelung in der bekannten Weise.

Statt des bisher vorhandenen Rückkoppelungskondensators C besteht nun erfindungsgemäss der Rückkopplungszweig des Oszillators neu aus den Kopplungselementen K1 und K2. Dabei koppelt K1 in bekannter Weise die Energie zur Kompensation der Verluste der Gruppe 1 in temperaturkompensierender Weise ein. Erfindungsgemäss wird nun die Energie zur Kompensation der temperaturunabhängigen Verluste (Gruppe 2) temperaturunabhängig veränderbar über K2 eingekoppelt ; die Energie für Verluste, deren Temperaturkoeffi-

2

zient in oben beschriebener Weise durch Ueberlagerung gebildet werden muss, wird durch geeignete Aufteilung über K1 und K2 eingekoppelt. Verluste, deren Temperaturkoeffizienten infolge Nichtlinearität nicht ideal durch die erwähnte Ueberlagerung nachgebildet werden können, müssen möglichst klein gehalten werden. Sie werden dann durch bestmögliche Approximation auf die beiden Gruppen verteilt.

Erfindungsgemäss von besonderer Bedeutung ist nun Rm im Falle des induktiven Näherungsschalters. Bei Geräten mit fest eingestelltem Schaltpunkt kann auch Rm als fest betrachtet werden, nämlich mit seinem Wert im Schaltpunkt. Bei Näherungsschaltern mit variablem Schaltpunkt bzw. ohne Schaltpunkt (lineare Näherungsschalter) ist dies nicht der Fall, und die Temperaturkompensation kann nur an einem Punkt optimal sein. Je grösser die Entfernung von diesem Punkt, um so schlechter wird die Temperaturkompensation sein. Erfindungsgemäss wird dieses Problem so gelöst, dass die durch Rm dargestellten variablen Verluste im Messplättchen durch Variation der Kopplung über das Kopplungselement K2 kompensiert werden. Es resultiert eine optimale Temperaturkompensation des Schaltabstandes des Näherungsschalters für alle Werte von Rm.

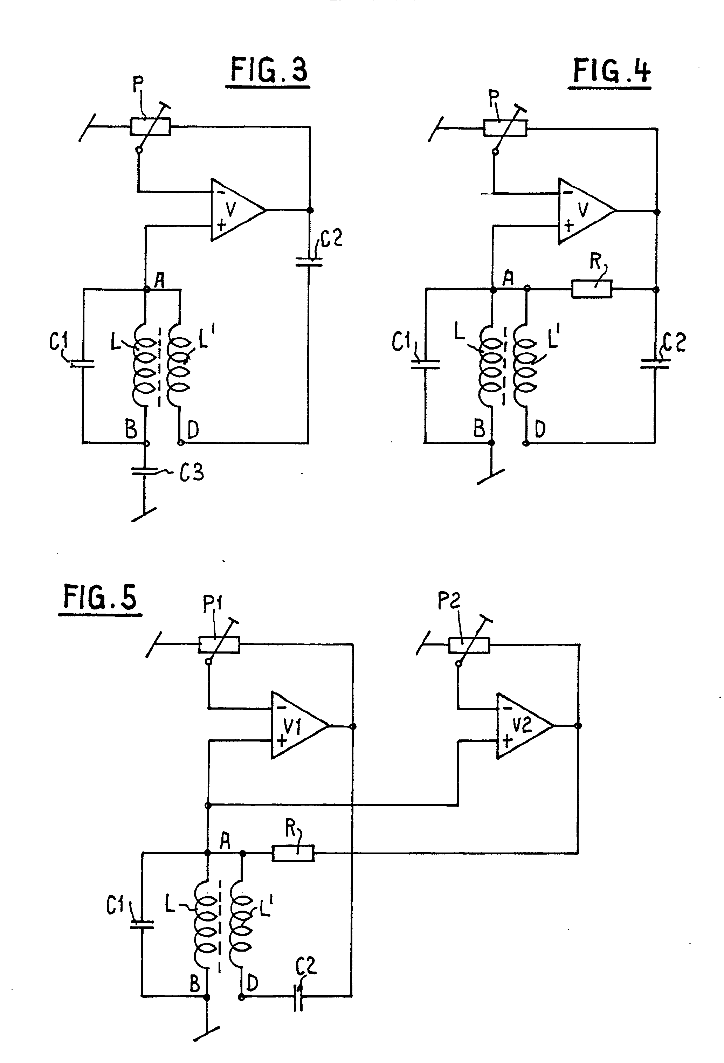

Gemäss Fig. 3 besteht das Koppelelement K1 in bekannter Weise aus einem Kondensator C2. K2 wird durch den kapazitiven Spannungsteiler C2-C3 gebildet, der das Auftreten einer temperaturunabhänigen Spannung am Punkt B bewirkt und damit dir gewünschte durch Anderung eines kondersators änderbare, aber temperaturunabhängige Rückkopplung ermöglicht. Eine Widerstandsänderung in den Spulen L und L' wirkt sich hierbei praktisch nicht aus.

Gemäss Fig. 4 ist K1 unverändert, aber K2 besteht jetzt aus dem Widerstand R, der wiederum die gewünschte temperaturunabhängige aber einstellbare Rückkopplung bewirkt.

Gemäss Fig. 5 ist K1 in bekannter Weise über V1 und C2 ausgeführt. K2 besteht hier aus einem separaten Verstärker V2 und dem aus Fig. 4 bekannten Widerstand R. Der Vorteil dieser Anordnung besteht darin, dass hier die Rückkopplung über K2 mittels des Potentiometers P2 variiert werden kann, was schaltungstechnisch wesentlich einfacher durchzuführen ist als eine Veränderung von R.

K1 und K2 sind so zu dimensionieren, dass typischerweise ca. 80% der Energie über K1 rückgekoppelt werden und der Rest über K2. Das genaue Verhältnis hängt von den jeweiligen Verhältnissen im LC-Kreis ab.

**Patentansprüche**

1. Verfahren zur Reduktion der Temperaturabhängigkeit der Schwingparameter eines LC-Oszillators, dessen Rückkoppelungspfad in zwei Teilpfade (K1, K2) aufgeteilt wird, deren erster (K1) so temperaturabhängig ist, dass dadurch die Schwingkreisverluste mit kupfergleichen Temperaturkoeffizienten ausgeglichen werden und deren zweiter (K2) temperaturunabhängig ist, womit die temperaturkonstanten Verluste ausgeglichen werden können, dadurch gekennzeichnet, dass in Abhängigkeit einer variablen äusseren Bedämpfung, nur die Rückkoppelung über den temperaturunabhängigen (K2) verändert wird.

2. Verfahren nach Anspruch 1, dadurch gekennzeichnet, dass die Verluste mit Temperaturkoeffizienten, die weder demjenigen des Kupfers entsprechen noch konstant sind, durch geeignete Aufteilung auf die beiden Pfade (K1, K2) kompensiert werden.

3. Verfahren nach Anspruch 1 oder 2, dadurch gekennzeichnet, dass eine kombinierte ohmsche und kapazitive Rückkoppelung erfolgt, wobei der temperaturkonstante Rückkoppelungspfad durch einen kapazitiven Spannungsteiler (C2-C3) geführt wird.

4. Verfahren nach Anspruch 1 oder 2, dadurch gekennzeichnet, dass die temperaturkonstante Rückkoppelung (K2) über einen zwischen den Ausgang des Verstärkers (V) und einer Klemme (A) des Schwingkreises geschalteten Widerstand (R) erfolgt.

5. Verfahren nach Anspruch 1 oder 2, dadurch gekennzeichnet, dass die beiden Rückkoppelungspfade über getrennte, regelbare Verstärker (V1 und V2) geführt werden.

6. Schaltung zur Reduktion der Temperaturabhängigkeit der Schwingparameter eines LC-Oszillators mit variabler äusserer Bedämpfung, insbesondere eines Näherungsschalters, mit mindestens einem Verstärker (V) und einer Rückkoppelung die in zwei Teilpfade (K1, K2) aufgeteilt ist, wobei der erste Rückkoppelungspfad (K1) so temperaturabhängig ist, dass dadurch die Schwingkreisverluste mit kupfergleichen Temperaturkoeffizienten ausgeglichen sind und deren zweiter Rückkoppelungspfad (K2) temperaturunabhängig ist, womit die temperaturunabhängigen Verluste ausgeglichen sind, dadurch gekennzeichnet, dass ein Rückkoppelungsanschluss (A) des Schwingkreises (L, C1) mit einem Eingang des Verstärkers (V) verbunden ist und der temperaturunabhängige Rückkoppelungspfad (K2) in Abhängigkeit der äusseren Bedämpfung variabel ist und zwischen dem Verstärkerausgang und dem Rückkoppelungsanschluss (A) liegt, während der temperaturabhängige Rückkoppelungspfad (k1) vom Verstärkerausgang über eine mit der Schwingkreisspule (L) bifilar gewickelte Spule (L') zum Rückkoppelungsanschluss (A) geführt ist.

7. Schaltung nach Anspruch 6, dadurch gekennzeichnet, dass in jedem Rückkoppelungspfad ein separa-

EP 0 319 470 B1

ter, regelbarer Verstärker liegt.

## Claims

1. A method for the reduction of the temperature dependence of the oscillating parameters of an LC oscillator whose feedback path is divided into two partial paths (K1, K2), the first one (K1) of which is temperature-dependent in such a manner that the oscillator losses according to temperature coefficients corresponding to that of copper are compensated, and the second (K2) of which is temperature-independent and allows the compensation of temperature-constant losses, characterized in that only the feedback through the temperature-independent path (K2) is varied as a function of a variable external damping.

2. A method according to claim 1, characterized in that the losses according to temperature coefficients which do neither correspond to that of copper nor are constant are compensated by an appropriate distribution thereof between the two paths (K1, K2).

3. A method according to claim 1 or 2, characterized in that a combined resistive and capacitive feedback is provided, the temperature-constant feedback path passing through a capacitive voltage divider (C2-C3).

4. A method according to claim 1 or 2, characterized in that the temperature-constant feedback (K2) is effected through a resistor which is connected between the output of the amplifier (V) and a terminal (A) of the oscillator.

5. A method according to claim 1 or 2, characterized in that the two feedback paths run through separate, controllable amplifiers (V1 and V2).

6. A circuit for the reduction of the temperature dependence of the oscillating parameters of an LC oscillator having a variable external damping, in particular of a proximity switch, said circuit comprising at least an amplifier (V) and a feedback which is divided into two partial paths (K1, K2), the first feedback path (K1) being temperature-dependent in such a manner that the oscillator losses according to temperature coefficients corresponding to that of copper are compensated, and the second feedback path (K2) being temperature-independent and compensating the tempatureindependent losses, characterized in that one feedback terminal (A) of the oscillator (L, C1) is connected to the input of the amplifier (V), and that the temperature-independent feedback path (K2) is variable as a function of the external damping and is connected between the amplifier output and the feedback terminal (A), while the temperature-dependent feedback path (K1) runs from tie amplifier output to the feedback terminal (A) via a coil (L') which is double-wound with the oscillator coil (L).

7. A circuit according to claim 6, characterized in that a separate, controllable amplifier is provided in each feedback path.

## Revendications

1. Procédé pour la réduction de la dépendance en température des paramètres d'oscillation d'un oscillateur LC dont le chemin de rétroaction est divisé en deux chemins partiels (K1, K2) dont le premier (K1) est dépendant de la température de telle sorte que les pertes de l'oscillateur selon des coefficients de température correspondant à celui du cuivre sont compensées, et dont le deuxième (K2) est indépendant de la température et permet la compensation des pertes à température constante, caractérisé en ce que seule la rétroaction par le chemin indépendant de la température (K2) est modifiée en fonction d'un amortissement extérieur variable.

2. Procédé selon la revendication 1, caractérisé en ce que les pertes à coefficients de température qui ne correspondent pas à celui du cuivre et qui ne sont pas constantes, sont compensées par une répartition appropriée sur les deux chemins (K1, K2).

3. Procédé selon la revendication 1 ou 2, caractérisé en ce qu'une rétroaction combinée ohmique et capacitive est effectuée, le chemin de rétroaction constant en température passant par un diviseur de tension capacitif (C2-C3).

4. Procédé selon la revendication 1 ou 2, caractérisé en ce que la rétroaction constante en température (K2) est effectuée par une résistance (R) connectée entre la sortie de l'amplificateur (V) et une borne (A) de l'oscillateur.

5. Procédé selon la revendication 1 ou 2, caractérisé en ce que les deux chemins de rétroaction passent par des amplificateurs réglables séparés (V1 et V2).

6. Circuit pour la réduction de la dépendance en température des paramètres d'oscillation d'un oscillateur LC à amortissement extérieur variable, en particulier d'un détecteur de proximité, comprenant au moins un amplificateur (V) et un chemin de rétroaction divisé en deux chemins partiels (K1, K2), le premier chemin de rétroaction (K1) étant dépendant de la température de telle sorte que les pertes de l'oscillateur selon des coef-

4

ficients de température correspondant à celui du cuivre sont compensées, et le deuxième chemin rétroactif (K2) étant indépendant de la température et compensant les pertes indépendantes de la température, caractérisé en ce qu'une borne de rétroaction (A) de l'oscillateur (L, C1) est reliée à une entrée de l'amplificateur (V), et que le chemin de rétroaction indépendant de la température (K2) est variable en fonction de l'amortissement extérieur et est connecté entre la sortie de l'amplificateur et la borne de rétroaction (A), tandis que le chemin de rétroaction dépendant de la température (K1) passe de la sortie de l'amplificateur à la borne de rétroaction (A) par l'intermédiaire d'une bobine (L') qui est bobinée de manière bifilaire avec la bobine (L) de l'oscillateur.

7. Circuit selon la revendication 6, caractérisé en ce qu'un amplificateur réglable séparé se trouve dans chaque chemin de rétroaction.

## FIG.1

## FIG.2

# FIG.3

# FIG.4

# FIG.5